# EUROPEAN PATENT SPECIFICATION

(11) **EP 2 006 349 B1**
(45) Date of publication and mention of the grant of the patent: **18.11.2015**
(21) Application number: 07715019.1
(22) Date of filing: 27.02.2007
(51) Int. Cl.: C09K 11/65, C01B 31/06, C09K 11/00, C23C 16/27, G01T 1/202, G01T 1/29

(54) **BEAM DETECTING MEMBER AND BEAM DETECTOR USING IT**
STRAHLENDETEKTORELEMENT UND DAVON GEBRAUCH MACHENDER STRAHLENDETEKTOR
ELEMENT DE DETECTION DE FAISCEAU ET DETECTEUR DE FAISCEAU L'UTILISANT

(30) Priority: 02.03.2006 JP 2006056750; 05.01.2007 JP 2007000673
(43) Date of publication of application: 24.12.2008
(73) Proprietor: Kabushiki Kaisha Kobe Seiko Sho (Kobe Steel, Ltd.), Kobe-shi, Hyogo 651-8585 (JP)
(72) Inventor: KOBASHI, Koji c/o Kobe Steel, Ltd., Kobe-shi, Hyogo 651-2271 (JP); TACHIBANA, Takeshi c/o Kobe Steel, Ltd., Kobe-shi, Hyogo 651-2271 (JP); YOKOTA, Yoshihiro c/o Kobe Steel, Ltd., Kobe-shi, Hyogo 651-2271 (JP); HAYASHI, Kazushi c/o Kobe Steel, Ltd., Kobe-shi, Hyogo 651-2271 (JP)
(74) Representative: Müller-Boré & Partner Patentanwälte PartG mbB
(86) International application number: PCT/JP2007/053684
(87) International publication number: WO 2007/099973

(56) References cited:
- EP-A1- 0 736 780
- JP-A- 03 020 691
- JP-A- 03 281 594
- JP-A- 07 167 959
- JP-A- 08 297 166
- JP-A- 2004 095 958
- JP-A- 2005 045 114
- US-A- 5 444 251

## Description

### Technical Field

The present invention relates to a beam detector for detecting the position, intensity, and the like of beam light by irradiating a beam irradiation portion with the beams, such as high-energy synchrotron radiation, generated by a synchrotron radiation facility or the like and to a beam monitor using the above beam detector.

### Background Art

In recent years, in research and development in the fields of medical care, materials, electronics, and the like, synchrotron radiation facilities and the like, which generate ultraviolet beams to x-ray beams, have been widely utilized. Since these beams cannot be recognized by the naked eye, it is not easy to precisely detect the position of the beams as described above, and hence the adjustment of an optical system is difficult.

In addition, since energy of synchrotron radiation is high, dangerous accidents may occur in some cases such that an object not to be irradiated or an experimenter is irrdiated with high energy light by mistake, or such that an experimenter is unconsciously and indirectly irradiated with a large amount of x rays. Hence, a beam monitor and/or a beam detection method, which can easily measure the position of radiation beams in a short period of time, has been required. In general, since the energy of synchrotron radiation is high, a fluorescent plate itself, which is used to observe the position or the like of electron beams, is damaged thereby; hence, it cannot be used for the purpose described above.

Next, a beam monitor or a beam detection method according to a conventional example will be described with reference to Figs. 8 to 10. Fig. 8 is a schematic structural view showing one example of an x-ray beam monitor device according to a conventional example; Fig. 9 includes an overhead view and a cross-sectional view, each schematically illustrating one example of a synchrotron radiation position.monitor according to a conventional example; and Fig. 10 is a perspective view showing the structure of one example of a beam monitor according to a conventional example.

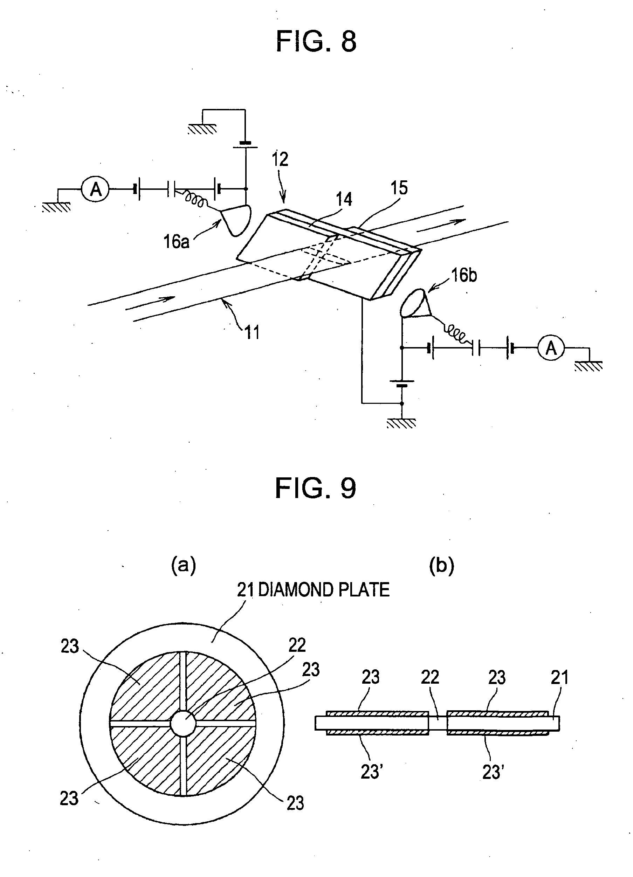

First, as shown in Fig. 8, the transmission x-ray beam monitor device according to the conventional example has the structure in which photoelectric films 14 and 15 are formed on a half of a front surface and a half of a rear surface of a monitor plate 12. In this x-ray beam monitor, when x-ray beams 11 are irradiated, electrons (photoelectrons) are emitted from the photoelectric films 14 and 15, and the electron amounts emitted from the individual surfaces are measured by secondary electron multiplier tubes 16a and 16b. Since the photoelectric film 14 on the front surface and the photoelectric film 15 on the rear surface are disposed so as not to be overlapped with each other, one-dimensional displacement of the beams 11 from the central position can be measured (see Patent Document 1).

However, the above x-ray beam monitor according to the conventional example can estimate the one-dimensional central position (for example, along the x coordinate) but cannot determine a two-dimensional position (along the y coordinate). In order to determine the position along the y coordinate, a second beam monitor is necessarily provided so as to be perpendicular to the first beam monitor.

However, by the structure as described above, since radiation beams pass through the above monitors twice, absorption and scattering of the beams occur, and hence the quality of the beams are disadvantageously degraded. In addition, signals generated by emitted electrons interfere with each other, and hence, a problem may also occur in that a precise beam central position cannot be determined.

Next, as shown in Fig. 9, the synchrotron radiation position monitor according to the conventional example uses a vapor phase-synthesized diamond plate 21 in the form of a disc having a bore 22 at the center, and around the periphery thereof, four divided metal electrodes 23 and 23' in the form of fans are disposed on two surfaces of the diamond plate 21. When the metal electrodes 23 and 23' are irradiated with synchrotron radiation, since photoelectrons are emitted, by monitoring a photoelectron current, the central position of the radiation beams is estimated. In the synchrotron radiation position monitor according to the conventional example, since the four divided metal electrodes 23 and 23' are disposed, the (x, y) coordinates of the central position of the radiation beams can be determined (see Patent Document 2).

In the synchrotron radiation position monitor described above, in order to detect the central position of beams, the beam central position is estimated from current of photoelectrons generated from the electrodes 23 and 23' facing each other with the diamond plate 21 interposed therebetween. However, the estimation as described above can be reasonable as long as the cross-sectional distribution of beam intensity has a perfect circular shape. In general, the cross-sectional distribution of beam intensity may show a deformed oval shape or a shape including two circles overlapped with each other, and in addition, the cross-sectional distribution changes with time.

Accordingly, the synchrotron radiation position monitor according to the conventional example has problems in that the beam position cannot be precisely estimated and in that the change in cross-sectional distribution cannot also be grasped. Furthermore, by the monitoring method according to the conventional example, when radiation beams are largely shifted from the bore 22 located at the center of the synchrotron radiation position monitor, it does not work at all. That is, there has been a self-contradiction that when the position of the radiation beams is not known beforehand, the radiation beam position cannot be monitored.

In addition, since a synchrotron radiation position monitor according to another conventional example has a structure similar to that shown in Fig. 9, it will be described with reference to Fig. 9; that is, the method of this monitor is that current (photocurrent) between the electrodes 23 and 23' disposed on the two surfaces of the diamond plate 21 is measured instead of that caused by electron emission, so that the central position of radiation beams is estimated. Although the radiation beams described above have a spread to a certain extent, when light beams present in the periphery of the above beams, having relatively low intensity, pass through the diamond plate 21 provided between the electrodes 23 and 23', a large number of electron-hole pairs are generated in the diamond, and the generated electrons and holes move to the respective positive and negative electrodes 23 and 23', so that the current flows between the electrodes (see Patent Document 3).

The synchrotron radiation position monitor of the above conventional example is a monitor to measure photocurrent flowing between the electrodes 23 and 23' facing each other with the diamond plate 21 interposed therebetween, as shown in Fig. 9. However, in general, since the film quality of a diamond plate formed by a vapor phase synthesis is not uniform, even when beams are irradiated to a position monitor in a symmetrical manner, outputs from individual electrodes cannot be equivalent to each other, and as a result, there has been a problem in that the beam position cannot be precisely estimated. In addition, as the case described in the above Patent Document 2, when the radiation beams are largely shifted from the center of the synchrotron radiation position monitor, it does not work at all.

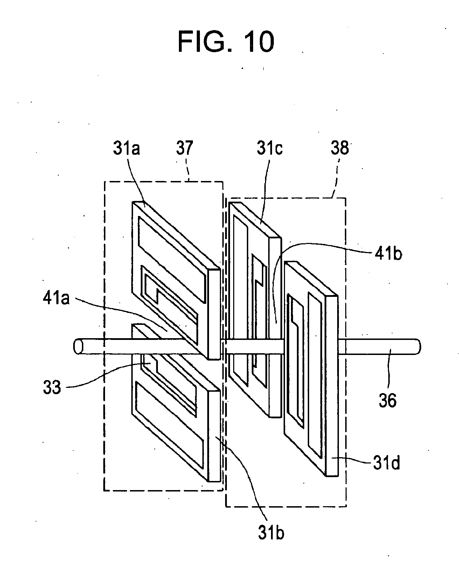

Furthermore, as shown in Fig. 10, a beam monitor proposed as another conventional example has a first unit 37 composed of a pair of diamond plates 31a and 31b, which are disposed so that the end surfaces thereof are separated parallel to each other and which each have electrodes 33 on two surfaces, and a second unit 38 disposed apart from the first unit 37 in the direction in which beams to be measured travel.

In addition, at the same time, in the second unit 38 of this beam monitor, at least one set of a pair of diamond plates 31c and 31d, which are disposed so that the end surfaces thereof are separated parallel to each other and which each have electrodes 33 on two surfaces, is disposed in the direction in which beams 36 to be measured travel, and at least one set of diamond plates among the diamond plates 31a, 31b, 31c, and 31d forming the first unit 37 and the second unit 38 can adjust gaps 41a and 41b therebetween (see Patent Document 4).
Patent Document 1: Japanese Unexamined Patent Application Publication No. 7-318657
Patent Document 2: Japanese Unexamined Patent Application Publication No. 8-279624
Patent Document 3: Japanese Unexamined Patent Application Publication No. 8-297166
Patent Document 4: Japanese Unexamined Patent Application Publication No. 11-174199

EP0736780 discloses an x-ray beam position monitor, including a diamond plate placed so that the X-ray beam pass through the diamond plate, and a plurality of electrode pairs placed on both sides of the diamond plate. A low resistivity to be formed in the diamond plate can be formed by doping sufficient amount of impurities while diamond is made grown by vapor phase synthesis. Impurities to be doped include, for instance, B, Al, Li, P and Se.

### Disclosure of Invention

### Problems to be Solved by the Invention

The above beam monitor is formed by doping boron in the diamond plates 31a, 31b, 31c, and 31d. However, the measurement principle of the beam monitor according to this conventional example is to measure current generated in the diamond plates, and in order to obtain a diamond plate having a low resistivity, the doping is merely performed using boron. Hence, there has been a problem similar to that of the synchrotron radiation position monitor proposed in the Patent Document 2 according to the above conventional example.

That is, there have been problems in that the beam position cannot be precisely estimated and the change in cross-sectional distribution cannot also be grasped. In addition, when radiation beams are largely shifted from the center of the synchrotron radiation position monitor, it does not work at all. That is, there has been a self-contradiction that when the position of the radiation beams is not known beforehand, the radiation beam position cannot be monitored.

The present invention has been conceived in consideration of the problems described above, and an object of the present invention is to provide a beam detector and a beam monitor using the same, the beam detector being capable of precisely and stably detecting, for a long period of time, the position, the intensity distribution, and the change with time of radiation beams, soft x-ray beams, and the like, which are from high energy to low energy; and being manufactured at a low cost as compared to that of a conventional detection device.

### Means for Solving the Problems

In order to achieve the above object, according to means employed by a beam detector according to the present invention, at least one beam irradiation portion of the beam detector for detecting the position and intensity of beams is formed of a free-standing diamond film, and this diamond film is a polycrystalline diamond film (C) containing at least one element (X) selected from the group consisting of silicon (Si), nitrogen (N), lithium (Li), beryllium (Be), boron (B), phosphorus (P), sulfur (S), nickel (Ni), and vanadium (V).

At the same time, the beam detector is characterized in that since the beam detector is designed so that at least one element selected from the above elements X is contained in the polycrystalline diamond film at an X/C of 0.1 to 1,000 ppm, a light emission function of emitting light is imparted to the polycrystalline diamond film when it is irradiated with beams.

The beam detector is also characterized in that the beams are synchrotron radiation beams and the diamond film uses a polycrystalline diamond film which emits light in a beam irradiation region at an energy of 5 to 300 keV.

The beam detector is also characterized in that at least part of the diamond film is held by a substrate and the polycrystalline diamond film has a film thickness of 0.1 µm to 3 mm.

The beam detector is also characterized in that the polycrystalline diamond film includes diamond grains having an average grain diameter of 0.1 µm to 1 mm.

The beam detector is also characterized in that the light emission wavelength is 150 to 800 nm. ,

The beam detector is also characterized in that the light emission has a peak intensity in a wavelength region of 730 to 760 nm.

The beam detector is also characterized in that the light emission has a peak intensity in a wavelength region of 500 to 600 nm.

The beam detector is also characterized in that the polycrystalline diamond film has a surface flatness of 30 to 100 nm.

The beam detector is also characterized in that a plurality of the beam detectors is assembled to form a module structure.

The beam detector is also characterized in that the polycrystalline diamond film forms a free-standing film structure and this free-standing film portion is the beam irradiation portion to be irradiated with beams.

The beam detector is also characterized in that the polycrystalline diamond film includes the beam irradiation portion and a thick film portion having a thickness larger than that of the beam irradiation portion.

The beam detector is also characterized in that the substrate is a silicon substrate or a composite in which a thin film of silicon dioxide is provided between a substrate and a polycrystalline diamond film.

Means employed by a beam monitor according to the present invention is characterized in that a beam monitor having a beam detector for detecting the position and intensity of beams, comprises the beam detector of the present invention and light emission observation means for observing the above light emission phenomenon, and in that by a light emission state observed by this light emission observation means, the position and intensity of the beams are detected.

The beam monitor is also characterized in that the beams are radiation beams, the diamond film uses a polycrystalline diamond film which emits light in a beam irradiation region at an energy of 5 to 300 keV, and the light emission observation means includes a camera.

### Advantages

Since the beam detector of the present invention includes a beam irradiation portion, which is formed using at least a polycrystalline diamond film, for detecting the position and intensity of beams, and this polycrystalline diamond film is a polycrystalline diamond (C) film containing at least one element (X) selected from the group consisting of silicon (Si), nitrogen (N), lithium (Li), beryllium (Be), boron (B), phosphorus (P), sulfur (S), nickel (Ni), and vanadium (V) at an X/C of 0.1 to 1,000 ppm, when the beams are irradiated to this diamond film, a light emission function of emitting light is imparted thereto: hence, monochromatic light, such as visible light or ultraviolet light, having sufficient intensity can be obtained from a beam irradiation spot.

Visible light excited inside the diamond film is emitted outside the film while being scattered by minute crystalline grain boundaries present inside the polycrystalline diamond film. Hence, precisely speaking, the beam diameter is detected larger than the actual beam diameter by the order of micrometers due to the spread of the beams. However, in practice, the spread on the order of micrometers will cause no problems. On the other hand, when the diamond film is formed of a single crystal, since grain boundaries are not present in the film, internal scattering does not occur; however, excited visible light is reflected on the film surface and is then extracted outside the film from an edge portion of a sample. As a result, a beam spot is not observed, and hence the single crystal cannot be used for the beam position detection.

In addition, in the beam detector of the present invention, since the beams are radiation beams, the diamond film uses a polycrystalline diamond film which emits light in a beam radiation region at an energy of 5 to 300 keV, and the light emission wavelength is 150 to 800 nm, when light emission is in the visible light region, the irradiation spot of the radiation beams can be recognized by the naked eye, and hence the irradiation position of the beams can be identified by the naked eye.

Furthermore, in the beam detector of the present invention, since at least part of the diamond film is held by a substrate, the film thickness of the polycrystalline diamond film is 0.1 µm to 3 mm, and the average grain diameter of diamond grains is 0.1 µm to 1 mm, high-quality transmission radiation beams having a suitable light emission region size and appropriate light emission luminance can be obtained.

In addition, in the beam detector of the present invention, since the light emission has a peak intensity in a wavelength region of 730 to 760 nm or 500 to 600 nm, which is the light emission relating to silicon (Si) and boron (B), respectively, contained in the polycrystalline diamond film, the light emission intensity is particularly significant; hence, the light emission can be easily detected, so that the beam position can be identified.

In the beam detector of the present invention, since the surface flatness of the polycrystalline diamond film is 30 to 100 nm, the light emission intensity by radiation beams is improved by 2 to 5 times as compared to that of an unpolished diamond film.

In addition, in the beam detector of the present invention, since a plurality of beam detectors is assembled to form a module structure, the positions and intensities of plural types of irradiation beams can be simultaneously detected and observed.

Furthermore, in the beam detector of the present invention, since the polycrystalline diamond film forms a free-standing film structure, and since this free-standing film portion is the beam irradiation portion to be irradiated with beams, no breakage occurs even by large current electron beams.

In addition, in the beam detector of the present invention, since the polycrystalline diamond film includes the beam irradiation portion and a thick film portion having a thickness larger than that of the beam irradiation portion, an increase in temperature of the beam irradiation portion can be suppressed.

In the beam detector of the present invention, since the substrate is a silicon substrate or a composite in which a thin film of silicon dioxide is provided between a substrate and a polycrystalline diamond film, the flatness of the substrate and the perpendicularity thereof to radiation beams can be easily ensured.

In addition, in the beam monitor of the present invention which is a beam monitor having a beam detector for detecting the position and intensity of beams, since the beam detector and light emission observation means for observing the above light emission phenomenon are provided, even when the light emission is performed in an invisible light region, by a light emission state observed by this light emission observation means, the position and intensity of the beams can be detected.

In addition, in the beam monitor of the present invention, since the beams are radiation beams, the diamond film uses a polycrystalline diamond film which emits light in a beam irradiation region at an energy of 5 to 300 keV, and the light emission observation means includes a camera, radiation beams in a wide wavelength region and in a wide energy range, which correspond to from a soft x-ray region to an ultraviolet ray region, can be monitored, and in addition, a clear spot image can be taken by using the above camera. In addition, by using a video camera or the like as the camera, the position and the intensity distribution of radiation beams can be measured in real time.

### Brief Description of Drawings

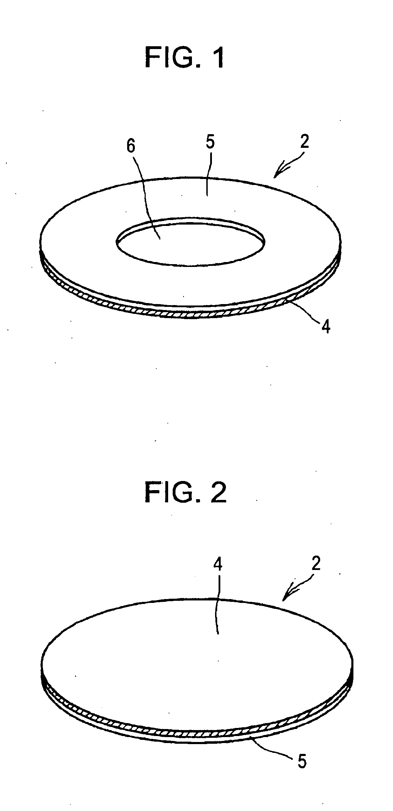

Fig. 1 is a schematic perspective view schematically showing a front surface of a beam detector according to embodiment 1 of the present invention.
Fig. 2 is a schematic perspective view schematically showing a rear surface of the beam detector according to the embodiment 1 of the present invention.

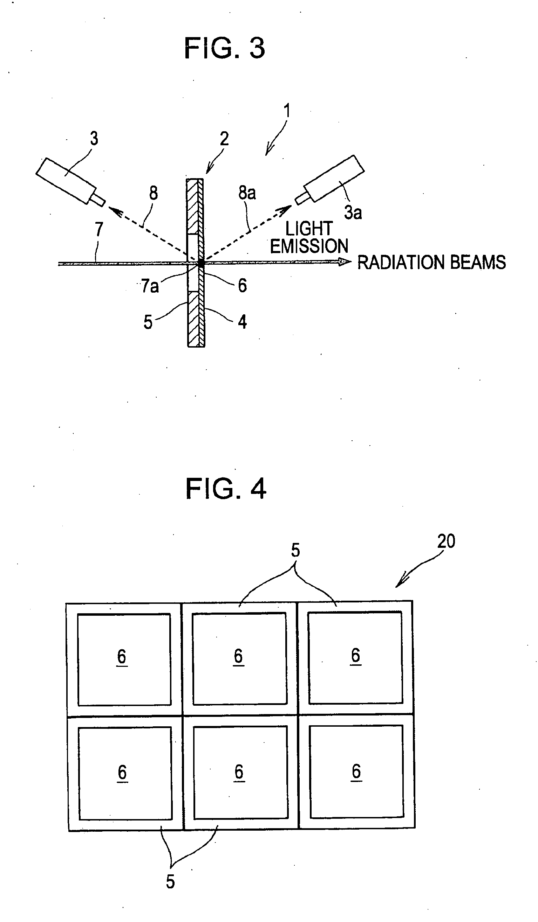

Fig. 3 is a schematic cross-sectional view schematically showing an entire structure of a beam monitor using the beam detector according to the embodiment 1 of the present invention.
Fig. 4 is a schematic plan view schematically showing a front surface of a beam detector according to embodiment 2 of the present invention.

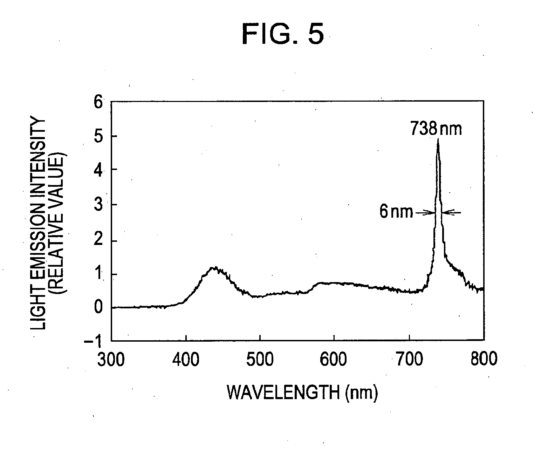

Fig. 5 is a view showing an observation example of a light emission spectrum obtained from a beam monitor according to the present invention, which has a beam detector including a polycrystalline diamond film doped with silicon (Si).

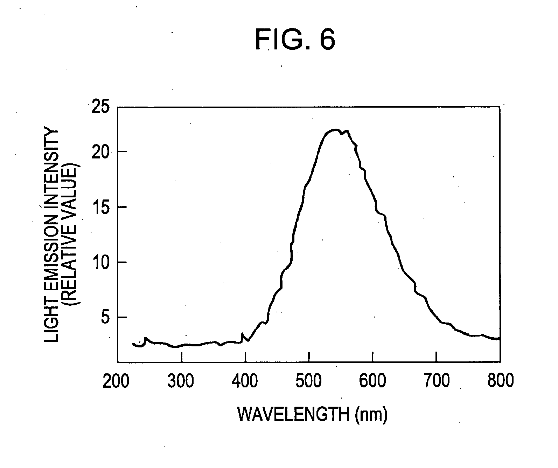

Fig. 6 is a view showing an observation example of a light emission spectrum obtained from a beam monitor according to the present invention, which has a beam detector including a polycrystalline diamond film doped with boron (B).

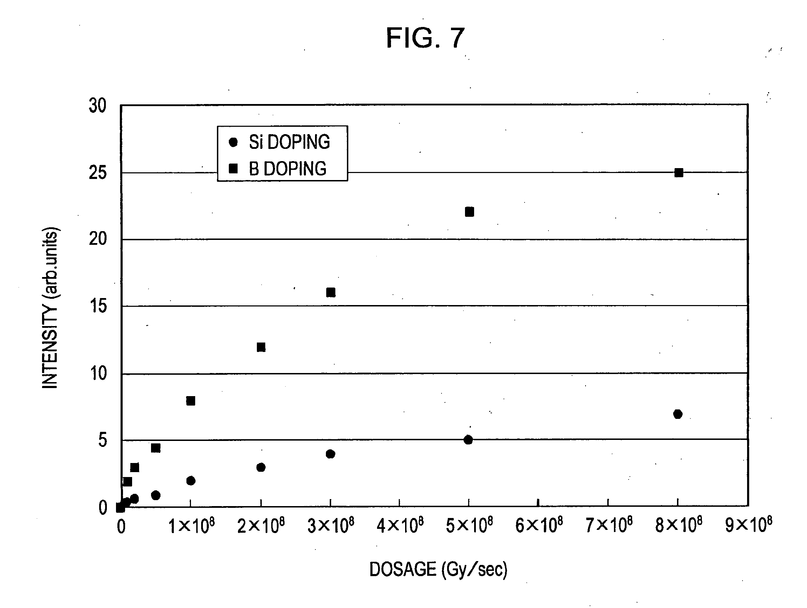

Fig. 7 is a view showing the intensity of an irradiation spot with respect to an x-ray dosage to a beam detector according to example 2 of the present invention.
Fig. 8 is a schematic structural view showing one example of an x-ray beam monitor device according to a conventional example.
Fig. 9 includes an overhead view and a cross-sectional view each schematically illustrating one particular example of a synchrotron radiation position monitor according to a conventional example.
Fig. 10 is a perspective view showing the structure of an example of a beam monitor according to a conventional example.

### Reference Numerals

- 1: beam monitor
- 2, 20: beam detector
- 3, 3a: light emission observation means
- 4: polycrystalline diamond film
- 5: substrate
- 6: beam irradiation portion
- 7: radiation beam
- 7a: beam irradiation spot
- 8, 8a: light emission

### Best Modes for Carrying Out the Invention

First, a beam detector according to embodiment 1 of the present invention and a beam monitor using the same will be described with reference to Figs. 1 to 3. Fig. 1 is a schematic perspective view schematically showing a front surface of the beam detector according to the embodiment 1 of the present invention, and Fig. 2 is a schematic perspective view schematically showing a rear surface of the beam detector according to the embodiment 1 of the present invention. In addition, Fig. 3 is a schematic cross-sectional view schematically showing an entire structure of a beam monitor using the beam detector according to the embodiment 1 of the present invention.

In a beam detector 2 according to the embodiment 1 of the present invention, as shown in Figs. 1 and 2, a polycrystalline diamond (C) film 4 is formed on a rear surface of a substrate 5, and the substrate 5 is a frame having a ring shape which is formed only along the periphery of the diamond film. In addition, the polycrystalline diamond film 4 is doped, for example, with silicon (Si) at an atomic ratio Si/C of 0.1 to 1,000 ppm.

Since Si atoms are incorporated in the polycrystalline diamond film 4, as described later with reference to Fig. 3, when radiation beams 7 are irradiated, light emission 8 of red monochromatic light having sufficient intensity is performed from an irradiation spot 7a. When the atomic ratio Si/C is less than 0.1 ppm, the light emission intensity is excessively low, and when the Si/C is more than 1,000 ppm, the crystallinity of the diamond film 4 is degraded, so that the light emission intensity is decreased. Furthermore, in particular, the atomic ratio Si/C is preferably in a range of 1 to 100 ppm and more preferably in a range of 5 to 50 ppm.

As other preferable elements to be doped in the polycrystalline diamond film 4, for example, there may be mentioned at least one element (X) selected from the group consisting of silicon (Si), nitrogen (N), lithium (Li), beryllium (Be), boron (B), phosphorus (P), sulfur (S), nickel (Ni), and vanadium (V).

In addition, when the element X as mentioned above is doped at an atomic ratio X/C of 0.1 to 1,000 ppm, and the polycrystalline diamond film 4 is irradiated with beams, from the radiation beam irradiation spot 7a, visible light, ultraviolet light, or the like having sufficient intensity can be obtained. The upper and the lower limits and the desired range of the total concentration (X/C) of the above impurities are similar to those in the case of the above Si.

In addition, in the beam detector 2, the substrate in a region of the beam irradiation portion 6 through which the radiation beams 7 are allowed to pass when being irradiated is removed, and the polycrystalline diamond film 4 has a free-standing structure as shown in Fig. 3. The structure as described above can be formed, for example, by the steps of using silicon as the substrate 5, masking a region other than that to be removed using an acid-resistant material, and then performing etching with a hydrofluoric acid-nitric acid solution.

It is preferable that the film thickness of the polycrystalline diamond film 4 be set small, such as 5 to 30 µm, at the beam irradiation portion 6 and be set large, such as 70 to 100 µm, at the other part on the substrate 5. The film thickness distribution of the polycrystalline diamond film 4 as described above can be realized using a selective growth technique of the diamond film 4. As described above, the reason the thickness of the diamond film 4 is set small at the beam irradiation portion 6 and is set large at the other part is to suppress an increase in temperature of the beam irradiation portion 6.

Since the beam detector 2 of the present invention has a simple structure as shown in Figs. 1 and 2, compared to the beam detectors each requiring a complicated production process disclosed in the Patent Documents 1 to 4 according to the conventional examples, the manufacturing cost can be significantly reduced.

In addition, as shown in Fig. 3, a synchrotron radiation detector 1 according to the embodiment 1 of the present invention has the beam detector 2 according to the embodiment 1 of the present invention as described above, and a light emission observation means 3 disposed at the irradiation side of the radiation beams 7. The polycrystalline diamond film 4 forming the beam irradiation portion 6 of the above beam detector 2 is irradiated with the radiation beams 7 to perform the light emission 8 from the polycrystalline diamond film 4, and this light emission 8 is observed by the light emission observation means 3, so that the irradiation spot 7a and the intensity of the beam light 7 are detected.

In the light emission phenomenon described above, since light emission from the beam irradiation spot 7a uniformly occurs in all directions, for example, light emission 8a to the rear side of the beam detector 2 can be observed by a light emission observation means 3a. The above light emission observation means 3 can use a general optical camera or digital camera, an ultraviolet CCD camera, a video camera, or the like.

As for the film thickness of the polycrystalline diamond film 4, the optimum value thereof is determined by the energy or energy density of the incident radiation beams 7. In general, an appropriate film thickness of the polycrystalline diamond film 4 is 0.1 µm to 3 mm. When the film thickness is less than 0.1 µm, since the light emission region is excessively small, the intensity of light emission is very low.

On the other hand, when the film thickness is more than 3 mm, the synthesis of the polycrystalline diamond film 4 takes a long time, the manufacturing cost is increased, and the transmitted radiation beams 7 are absorbed and scattered by the polycrystalline diamond film 4, so that the quality of the transmitted radiation beams 7 is degraded. Although being dependent on the application conditions, the film thickness of the polycrystalline diamond film 4 is more preferably in a range of 3 to 20 µm.

The grain diameter of the polycrystalline diamond film 4 has the relationship with the light emission luminance, and the average grain diameter is preferably in a range of 0.1 µm to 1 mm. When the average grain diameter is less than 0.1 µm, the amount of a non-diamond component is increased in the polycrystalline diamond film 4, and the crystalline defect density is also increased thereby, so that the light emission luminance is degraded.

On the other hand, when the average grain diameter is more than 1 mm, the film formation takes a long time, and the manufacturing cost is increased. In addition, the transmitted radiation beams 7 are absorbed and scattered by the diamond film having a large grain diameter, and the quality of the transmitted radiation beams 7 is degraded. When the synthesis time for the polycrystalline diamond film 4 is taken into consideration, the average grain diameter of diamond is more preferably in a range of 1 to 10 µm.

When the polycrystalline diamond film 4 of the present invention is irradiated with the radiation beams 7 at an energy of 5 to 300 keV, the light emission 8 having a light emission wavelength in a range of 150 to 800 nm can be emitted from the polycrystalline diamond film 4. When the light emission 8 is in the visible light region, the irradiation spot 7a of the radiation beams 7 can be recognized by the naked eye, and when the light emission 8 is in a region having a wavelength shorter than the visible light, by using an ultraviolet CCD camera as the light emission observation means 3, the irradiation spot 7a can be identified.

Furthermore, the surface flatness of the polycrystalline diamond film 4 is preferably in a range of 30 to 100 nm. When the surface flatness of the polycrystalline diamond film 4 is set in a range of 30 to 100 nm, the light emission intensity by the radiation beams 7 is improved by 2 to 5 times. The reasons the surface flatness is set as described above are that when the surface flatness is set to less than 30 nm, since a process must be performed for a particularly long time for forming the polycrystalline diamond, and polish-planarization of the film surface must be performed for a particularly long time, the cost is excessively increased, and that on the other hand, when the surface flatness is more than 100 nm, a light extraction rate is degraded by scattering of light at the film surface.

The surface flatness of the polycrystalline diamond film 4 can be improved by performing a mechanical and/or a chemical mechanical polishing process on the surface of this diamond film 4. As the polishing process as mentioned above, for example, there may be mentioned a chemical mechanical polishing method in which diamond is immersed in a polishing liquid containing abrasive grains, such as alumina, silica, or titania, dispersed in water, and polishing is performed on the surface of the diamond by abrasion, or a method in which in a vacuum chamber capable of controlling an oxygen partial pressure and an internal temperature, diamond is polished while metal oxides of iron, nickel, cobalt, and copper are reduced by carbon present in a surface layer portion of the diamond. In addition, the surface flatness can be easily measured by a stylus step measuring meter or a microscope using interference/phase difference of laser light.

Next, a beam detector according to embodiment 2 of the present invention will be described with reference to Fig. 4. Fig. 4 is a schematic plan view schematically showing a front surface of the beam detector according to the embodiment 2 of the present invention. The difference of the embodiment 2 from the embodiment 1 of the present invention is that an entire structure of the beam detector is not formed as that shown in Fig. 1. In addition, since the remaining structure is the same as described above, the same constituent elements as those of the embodiment 1 are designated by the same reference numerals as described above, and the different point will be describe below.

That is, as shown in Fig. 4, in a beam detector 20 according to the embodiment 2 of the present invention, a plurality of beam irradiation portions 6 is connected to each other in a plane to form a module structure. By the structure as described above, a detection range of beams can be increased. In addition, when the module as described above is formed, it is not always necessary to perform connection in a plane, and according to the application, connection may be performed to form a curved surface.

Next, an example in which a light emission spectrum from the beam monitor 1 of the present invention is observed will be described with reference to Figs. 5 and 6. Fig. 5 is an observation example of a light emission spectrum from the beam monitor according to the present invention, which has a beam detector including a polycrystalline diamond film doped with silicon (Si), and Fig. 6 is an observation example of a light emission spectrum from the beam monitor according to the present invention, which has a beam detector including a polycrystalline diamond film doped with boron (B).

First, in the example shown in Fig. 5 in which silicon (Si) was doped in the polycrystalline diamond film 4, by irradiation of the radiation beams 7, an intensive light emission band was observed at a wavelength of 738±0.5 nm (half-wave width: 6±0.5 nm). A bright red spot was taken by a video camera, and this is an effect of selecting an atomic ratio Si/C of Si in order to obtain a narrow light emission spectrum width and sufficient light emission intensity. In addition, in the example shown in Fig. 6 in which boron (B) was doped in the polycrystalline diamond film 4, by irradiation of the radiation beams 7, an intensive light emission band was observed at a wavelength of 540±10 nm.

As described above, the light emission preferably has a peak intensity in a wavelength region of 730 to 760 nm or 500 to 600 nm. The reason for this is that when the light emission 8 is in a wavelength range of 730 to 760 nm or 500 to 600 nm, which relates to silicon (Si) or boron (B), respectively, contained in the polycrystalline diamond film, since the intensity thereof is particularly significant, the light emission can be easily detected, and hence the beam position can be identified.

Since the beam detector 2 of the present invention is formed using diamond having a high thermal conductivity, no local overheating occurs at the radiation beam spot 7a. In addition, since diamond is formed of carbon, which has a small atomic number (that is, small number of electrons), the beam detector is characterized in that the interaction with radiation rays 7 is small and the absorption thereof hardly occurs. Accordingly, by providing the beam detectors 2 at the incident side and the transmission side of the radiation beams 7 with respect to a sample the position and the change in intensity of the radiation beams 7 can also be measured.

In addition, the surface flatness and the degree of parallelization (perpendicularity to the radiation beams) of the polycrystalline diamond film 4 of a free-standing diamond film 6 may become important in some cases. Hence, the grown surface of the polycrystalline diamond film 4 may be planarized by polishing or a silicon wafer having a flat surface may be used as the substrate, so that the surface flatness can be ensured.

In addition, in order to ensure the perpendicularity to the radiation beams 7, for example, there may be effectively used a method (1) in which a silicon plate having a thickness of approximately 1 cm is used as the substrate 5 so as to prevent the polycrystalline diamond film 4 being warped, and a method (2) in which part of the substrate 5 is coated with silicon dioxide beforehand so as to reduce the difference in thermal expansion coefficient between the diamond film 4 and the substrate 5.

Since the beam detector 2 of the present invention is formed using diamond having durability against radiation rays, besides synchrotron radiation, it can be used for measurement of high energy beams, such as electron beams and accelerated radiation particles. In particular, since the polycrystalline diamond film 4 is formed to have a free-standing film structure, it can be used as a detection portion which is not damaged even by large current electron beams.

In addition, although the typical embodiment of the beam detector 2 of the present invention is shown in Figs. 1 and 2, in the present invention, in principle, the polycrystalline diamond film 4 may be irradiated with the radiation beams 7 so as to cause the light emission (of visible light or ultraviolet light) 8 phenomenon; hence, a polycrystalline diamond film 2 is not always necessary to have a free-standing film structure. In addition, as the substrate 5, besides a silicon substrate, a high melting point metal or a ceramic may also be used, and a composite in which a thin film of silicon dioxide is provided between a substrate such as a silicon substrate and a polycrystalline diamond film may also be used. The modified examples as described above are also in the range of the present invention.

In addition, when the beam detector is used for the intensive radiation beams 7, an increase in temperature of the polycrystalline diamond film 4 of the beam irradiation portion 6 can be prevented by coating the substrate 5 and the polycrystalline diamond film 4 at a position other than the beam irradiation portion 6 with a metal film, such as aluminum, having a high thermal conductivity and superior workability, followed by connecting the above coating portion to a water cooling tool.

### Examples

### <Example 1>

By the following process, the beam detector 2 shown in Figs. 1 and 2 was formed. First, ultrasonic waves were applied on a silicon substrate having a diameter of 1 inch in an ethanol suspension containing a diamond powder having a diameter of several tens of micrometers, so that a treatment for promoting nuclear generation was performed. After diamond powder adhering on the substrate was washed out, the silicon substrate was placed in a microwave plasma CVD apparatus, so that a diamond film was formed. As a staring gas, a mixed gas containing 1 percent by volume of methane and 99 percent by volume of hydrogen was used. The gas pressure was set to 45 Torr and the substrate temperature was set to 800°C.

In order to incorporating Si in the polycrystalline diamond film, silane (SiH₄) or disilane (Si₂H₆) diluted with hydrogen was further added to the starting gas, or a silicon wafer piece was disposed beside the silicon substrate. As a result, by film formation performed for 8 to 30 hours, a polycrystalline diamond film having a thickness of 10 to 40 µm was obtained. It was confirmed that Si atoms were incorporated in the film at a concentration of 5 to 50 ppm. In addition, the average grain diameter of diamond grains of the film was approximately 20 µm.

Next, surface washing was performed on the polycrystalline diamond film in a saturated chromic acid-sulfuric acid solution at approximately 200°C, and surface washing was further performed in aqua regalis at 100°C. Subsequently, the rear surface of the silicon substrate was protected by a polyimide film which was not likely to be dissolved by a mixture of hydrofluoric acid and nitric acid and was then immersed in the above mixture, so that silicon in a region through which radiation beams were allowed to pass was removed.

The beam detector thus formed was placed on a holding table, and by using a color CCD camera as a light emission observation means, a beam monitor was formed. When radiation beams at an energy of 5 to 300 keV were irradiated to the beam irradiation portion, clear red light emission was observed from a polycrystalline diamond film region at an irradiation spot of the radiation beams. The measurement was performed by changing an acceleration voltage/beam current of synchrotron radiation, and it was confirmed that the luminance of the irradiation spot changed proportional to the energy of the synchrotron radiation. In addition, when the irradiation spot was magnified and then observed, it was found that the cross-sectional shape of beams changed in a complicated manner with time.

### <Example 2>

By a process similar to that in Example 1, diamond doped with boron was formed. In order to dope boron in a polycrystalline diamond film, diborane (B₂H₆) or trimethylboron (B(CH₃)₃) diluted with hydrogen was further added to the starting gas, or a piece of boric acid (B₂O₃) was disposed beside the silicon substrate. As a result, by film formation performed for 20 to 75 hours, a polycrystalline diamond film having a thickness of 15 to 48 µm was obtained. It was confirmed that boron atoms were incorporated in the film at a concentration of 1 to 100 ppm.

From the boron-doped diamond sample as described above, by a method similar to that in Example 1, part of the silicon substrate was processed by an etching treatment, so that a beam detector was formed. When the beam detector thus formed was irradiated with x-ray beams having an energy of 15 keV, from the polycrystalline diamond film at the irradiation spot, blue-green light emission was observed. In addition, when observation was performed by changing the dosage of x-ray beams to be irradiated, as shown in Fig. 7, the luminance of the irradiation spot changed proportional to the dosage. In addition, the Si doping shown in Fig. 7 indicates the change in light emission intensity of the sample formed in Example 1.

### <Example 3>

In a manner similar to that of Example 1, polycrystalline diamond films were formed by incorporating Si, N, Li, Be, B, P and S in polycrystalline diamond films each forming a beam detector. When these elements were incorporated in the polycrystalline diamond films, it was confirmed that the light emission of visible light to ultraviolet light was performed from the irradiation spot by the energy of synchrotron radiation. However, as shown in Table 1, the light emission spectra were significantly different from each other by the types of addition elements and the concentrations thereof.

**Table 1**

| Addition Element | Method for Adding Element to Diamond Film | Light Emission Wavelength (nm) |
|---|---|---|
| Si | SiH₄ or Si₂H₆ is added to starting gas. | 516-539, 738 |
| N | N₂ or NH₃ is added to starting gas. | 389, 415, 516-539, 575 |
| Li | Li ions are implanted. | 438 |
| Be | Metal Be is disposed on a substrate supporting table. | 516-539 |
| B | B₂H₆ is added to starting gas. | 443, 516-539 |
| P | PH₃ is added to starting gas. | 230, 516-539 |
| S | H₂S is added to starting gas. | 575, 516-539 |
| Ni | Ni ions are implanted. | 484, 516-539, 541, 602 |
| V | V ions are implanted. | 516-539, 770 |

In addition, it was also confirmed that when a plurality of elements was added, light emission was performed at respective light emission wavelengths of the added elements. When a plurality types of elements is added, 1 to 100 ppm of each element is preferably added, and 5 to 50 ppm thereof is further preferably added.

### <Example 4>

Polishing of the surfaces of the polycrystalline diamond films used for beam detection, which were formed in the above Examples 1 to 3, was performed by a chemical mechanical polishing method using an alumina abrasive grain-dispersed polishing liquid. Although an unpolished (as-grown) surface of the diamond film had a maximum height difference (peak-to-valley) of 3 µm, the surface flatness after the polishing treatment as described above was 30 to 100 µm.

In a manner similar to that in the Examples 1 to 3, beam detectors were obtained from the diamond films having a high surface flatness as described above by removing part of the substrate by etching. When these beam detectors were irradiated with x-ray beams under the same conditions as those of the Examples 1 to 3, followed by performing measurement of the light emission intensity, the luminance was obtained which was larger by approximately 2 to 5 times than that of the above Examples 1 to 3.

### <Example 5>

As the substrate, a silicon substrate (1 inch diameter) having a surface of the (001) plane was used. First, the silicon substrate was exposed to mixed plasma containing 5 percent by volume of methane and 95 percent by volume of hydrogen at a substrate temperature of approximately 800°C for 1 hour, so that the surface of the silicon substrate was carbonized. Next, a bias voltage of -200 V was applied to the above substrate for 20 minutes, so that diamond nuclei were formed on the entire substrate surface.

Subsequently, the application of the above bias voltage was stopped, and again by using a mixed gas containing 3 percent by volume of methane and 97 percent by volume of hydrogen, film formation was performed on the diamond surface by a microwave plasma CVD method for 6 hours. The gas pressure was set to 45 Torr, and the substrate temperature was set to 800°C. As a result, on the entire silicon substrate surface, a diamond film having a film thickness of 5 µm was formed.

Next, after a quartz-made disc having a diameter of 15 mm and a thickness of 0.2 mm was placed on the central portion of the substrate, and the substrate was again placed in a reaction chamber, diamond synthesis was performed for 80 hours using a mixed gas containing methane and hydrogen as that described above. As a result, only on the peripheral portion of the substrate which was not covered with the quartz-made disc, a diamond film having a thickness of 70 µm was formed.

Subsequently, after the quartz-made disc was removed, a 15-µm diameter region at the silicon substrate side was removed by etching using a mixture of hydrofluoric acid and nitric acid, so that a beam detector as shown in Figs. 1 and 2 was formed. The reason the film thickness of the polycrystalline diamond film at the peripheral portion is increased is to suppress an increase in temperature of the polycrystalline diamond film of the radiation beam irradiation portion by using a high thermal conductivity of diamond.

The beam detector thus formed was placed on a holding table, and by using a color CCD camera as the light emission observation means, a beam monitor was formed. When the beam irradiation portion is irradiated with synchrotron radiation having an energy of 5 to 300 keV, red light emission was observed from the radiation beam irradiation spot. When observation was performed by increasing an acceleration voltage/beam current, the light emission intensity proportional to the acceleration voltage/beam current was measured without causing damage on the beam irradiation portion.

In this Example 5, although an impurity element was not intentionally added, by a secondary ion mass spectroscopy (SIMS), Si at a concentration of 5 to 50 ppm was detected in the polycrystalline diamond film. The reason for this is believed that in the above process, the silicon substrate was etched by hydrogen plasma and the etched silicon was incorporated in the polycrystalline diamond film.

### <Comparative Example 1>

A diamond film was synthesized on a silicon substrate using a microwave plasma CVD apparatus. The content of a silicon element in this diamond was 0.07 ppm. The reason for this is believed that silicon atoms of the substrate were incorporated in the diamond film during the synthesis thereof. Although a beam irradiation portion of the beam detector thus formed was irradiated with radiation beams having a wavelength of 0.037 to 0.24 nm, the light emission was not observed. By using the other elements as those described above, a beam detector was also formed in which each element was added at a concentration of less than 0.1 ppm; however, the light emission was not observed.

### <Comparative Example 2>

A diamond film was synthesized using a microwave plasma CVD apparatus by addition of disilane (Si₂H₆) to a starting gas. The content of silicon in this diamond was approximately 1,200 ppm. The reason for this is believed that silicon atoms of the substrate were incorporated in the diamond film during the synthesis thereof.

The diamond film thus synthesized had a grain diameter of less than 0.1 µm. Although a beam irradiation portion of the beam detector thus formed was irradiated with radiation beams having an energy of 5 to 300 keV, the light emission was not observed. By using another element, a beam detector was also formed in which each element was added at a concentration of more than 1,000 ppm; however, the light emission was not observed.

The beam monitor of the present invention is a monitor for measuring light emission by the following method. That is, in the method mentioned above, since the atoms described above are incorporated in the polycrystalline diamond film forming the beam detector, each atom or the crystalline defect caused by the incorporation of each atom forms an intrinsic electron energy level, electrons are excited from the valence band to a high energy state by radiation beam irradiation, and through various energy relaxation processes, the light emission is observed when the electrons transit from a specific energy level or a plurality of electron energy levels to the valence band.

Although it has been known from a scientific point of view that diamond containing an impurity element generates light emission having a specific spectrum by electron energy excitation, no conventional examples have been reported in which visible light and/or ultraviolet light is generated by actually irradiating radiation beams and, in addition, in which this light emission is used for a position/intensity detection portion or a detector for radiation beams.

Since the beam detector of the present invention is formed of a diamond film having superior radiation resistance and a substrate, such as a silicon substrate, the performance is not degraded in a short period of time, unlike the other materials. In addition, for example, when Si atoms are doped into a polycrystalline diamond film under controlled conditions, light emission of red monochromatic light having a sufficient intensity is observed from a radiation beam irradiation spot, and by a beam monitor formed using a light emission observation means such as a general video camera, a clear spot image can be taken.

Accordingly, the beam detector of the present invention and the beam monitor using the same can measure the position and the intensity distribution of radiation beams in real time. In addition, since the radiation beams can always be monitored, an optical system for radiation beams can be finely adjusted by remote manipulation, and in addition, an accident in which an object not to be irradiated is irradiated by mistake with high-energy radiation beams can be prevented in advance. In addition, also in the case in which light emitted from the polycrystalline diamond film of the present invention is not visible light but ultraviolet light, by using an ultraviolet CCD camera as the light emission observation means, the position and the intensity distribution of radiation beams can be measured.

The beam monitor of the present invention can determine the beam position and the intensity distribution thereof such that, as described above, radiation beams are directly irradiated to the polycrystalline diamond film, and the position of light emission from the polycrystalline diamond film and the intensity distribution of the light emission are monitored using the light emission observation means. Since the area of the polycrystalline diamond film described above is not limited in principle, measurement can be easily performed in a region of several centimeters to several tens of centimeters in which radiation beams may move. Accordingly, even when the radiation beams are largely shifted from the standard position, the beam position can be detected.

In addition, since visible light can also be emitted from the radiation beam irradiation spot on the polycrystalline diamond film, it is characterized that the beam position, intensity, and distribution thereof can be directly observed without performing a complicated electron signal process. Since the beam monitor of the present invention is operated by the method as described above, problems, such as interference of electron signals and noise generation, do not occur at all. In addition, since the beam cross-sectional area is directly observed, even when the cross-sectional shape thereof is not a perfect circular shape and changes with time, the detection and the observation can be performed.

According to the beam detector of the present invention, since the polycrystalline diamond film is only required to emit light when it is irradiated with radiation beams having a wavelength in a range of 0.1 to 10 nm, which corresponds to light from soft x rays to ultraviolet rays, radiation beams having a wide energy range can be monitored in a wide wavelength region by the naked eye or a light emission observation means such as a camera. Furthermore, as the polycrystalline diamond film, since a material having a small thickness, such as several micrometers to several tens of micrometers, can be used, by the detector of the present invention, the radiation beams are not degraded nor scattered.

## Claims

1. A beam detector (2, 20) for detecting the position and intensity of synchrotron radiation beams (7), comprising: at least one free-standing diamond film which is to be irradiated with the synchrotron radiation beams (7), consisting of a polycrystalline diamond (C) film (4) containing at least one element (X) selected from the group consisting of silicon (Si), nitrogen (N), lithium (Li), beryllium (Be), boron (B), phosphorus (P), sulfur (S), nickel (Ni), and vanadium (V) at an X/C of 0.1 to 1,000 ppm, wherein the polycrystalline diamond film (4) has a light emission function of emitting light (8, 8a) when it is irradiated with the radiation beams (7).

2. The beam detector (2, 20) according to Claim 1, wherein the free-standing diamond film consisting of the polycrystalline diamond film (4) is adapted to emit light at a beam spot (7a) when irradiated with the synchrotron radiation beams (7) at an energy of 5 to 300 keV.

3. The beam detector (2, 20) according to Claim 1 or 2, wherein a part of the free-standing diamond film is held by a substrate (5), and the polycrystalline diamond film (4) has a film thickness of 0.1 µm to 3 mm.

4. The beam detector (2, 20) according to one of Claims 1 to 3, wherein the polycrystalline diamond film (4) includes diamond grains having an average grain diameter of 0.1 µm to 1 mm.

5. The beam detector (2, 20) according to one of Claims 1 to 4, wherein the wavelength of the emitted light (8, 8a) is 150 to 800 nm.

6. The beam detector (2, 20) according to one of Claims 1 to 4, wherein the light emission (8, 8a) has a peak intensity in a wavelength region of 730 to 760 nm.

7. The beam detector (2, 20) according to one of Claims 1 to 4, wherein the light emission (8, 8a) has a peak intensity in a wavelength region of 500 to 600 nm.

8. The beam detector (2, 20) according to one of Claims 1 to 7, wherein the polycrystalline diamond film (4) has a surface flatness of 30 to 100 nm.

9. The beam detector (2, 20) according to one of Claims 1 to 8, wherein a plurality of the free-standing diamond films is assembled to form a module structure.

10. The beam detector (2, 20) according to one of Claims 1 to 9, wherein the polycrystalline diamond film (4) contains the free-standing film structure (6), and this free-standing film portion (6) is the portion to be irradiated with the beams (7).

11. The beam detector (2, 20) according to one of Claims 1 to 10, wherein the polycrystalline diamond film (4) includes the free-standing diamond film and a thick film portion having a thickness larger than that of the free-standing diamond film.

12. The beam detector (2, 20) according to one of Claims 3 to 11, wherein the substrate (5) is a silicon substrate or a composite in which a thin film of silicon dioxide is provided between the substrate (5) and the polycrystalline diamond film (4).

13. A beam monitor (1) having a beam detector (2, 20) for detecting the position and intensity of synchrotron beams (7), comprising: the beam detector (2, 20) according to one of Claims 1 to 12; and light emission observation means (3, 3a) for observing the emitted light (8, 8a), wherein by a light emission state observed by the light emission observation means (3, 3a), the position and intensity of the synchrotron beams (7) are detected.

14. The beam monitor (1) according to Claim 13, wherein the free-standing diamond film consisting of the polycrystalline diamond film (4) is adapted to emit light (8, 8a) at a beam spot (7a) when irradiated with the radiation beams (7)'at an energy of 5 to 300 keV, and the light emission observation means (3, 3a) includes a camera.

## Patentansprüche

1. Strahlendetektor (2, 20) zum Detektieren der Position und Intensität von Synchrotronstrahlen (7), umfassend: mindestens einen freistehenden Diamantfilm, welcher mit den Synchrotronstrahlen (7) zu bestrahlen ist, bestehend aus einem polykristallinen Diamant-(C)-Film (4), enthaltend mindestens ein Element (X), ausgewählt aus der Gruppe, bestehend aus Silizium (Si), Stickstoff (N), Lithium (Li), Beryllium (Be), Bor (B), Phosphor (P), Schwefel (S), Nickel (Ni) und Vanadium (V), mit einem X/C von 0,1 bis 1.000 ppm, wobei der polykristalline Diamantfilm (4) eine Lichtemissionsfunktion des Emittierens von Licht (8, 8a) aufweist, wenn er mit den Strahlen (7) bestrahlt wird.

2. Strahlendetektor (2, 20) nach Anspruch 1, wobei der freistehende Diamantfilm, bestehend aus dem polykristallinen Diamantfilm (4), dafür geeignet ist, Licht an einem Strahlenpunkt (7a) zu emittieren, wenn er mit den Synchrotronstrahlen (7) mit einer Energie von 5 bis 300 keV bestrahlt wird.

3. Strahlendetektor (2, 20) nach Anspruch 1 oder 2, wobei ein Teil des freistehenden Diamantfilms von einem Substrat (5) gehalten wird, und der polykristalline Diamantfilm (4) eine Filmdicke von 0,1 µm bis 3 mm aufweist.

4. Strahlendetektor (2, 20) nach einem der Ansprüche 1 bis 3, wobei der polykristalline Diamantfilm (4) Diamantkörner einschließt, die einen durchschnittlichen Korndurchmesser von 0,1 µm bis 1 mm aufweisen.

5. Strahlendetektor (2, 20) nach einem der Ansprüche 1 bis 4, wobei die Wellenlänge des emittierten Lichts (8, 8a) 150 bis 800 nm beträgt.

6. Strahlendetektor (2, 20) nach einem der Ansprüche 1 bis 4, wobei die Lichtemission (8, 8a) eine Spitzenintensität in einem Wellenlängenbereich von 730 bis 760 nm aufweist.

7. Strahlendetektor (2, 20) nach einem der Ansprüche 1 bis 4, wobei die Lichtemission (8, 8a) eine Spitzenintensität in einem Wellenlängenbereich von 500 bis 600 nm aufweist.

8. Strahlendetektor (2, 20) nach einem der Ansprüche 1 bis 7, wobei der polykristalline Diamantfilm (4) eine Oberflächenebenheit von 30 bis 100 nm aufweist.

9. Strahlendetektor (2, 20) nach einem der Ansprüche 1 bis 8, wobei eine Mehrzahl der freistehenden Diamantfilme zum Bilden einer Modulstruktur angeordnet ist.

10. Strahlendetektor (2, 20) nach einem der Ansprüche 1 bis 9, wobei der polykristalline Diamantfilm (4) die freistehende Filmstruktur (6) enthält und dieser freistehende Filmabschnitt (6) der mit den Strahlen (7) zu bestrahlende Abschnitt ist.

11. Strahlendetektor (2, 20) nach einem der Ansprüche 1 bis 10, wobei der polykristalline Diamantfilm (4) den freistehenden Diamantfilm und einen Dickfilmabschnitt, aufweisend eine Dicke größer als die des freistehenden Diamantfilms, einschließt.

12. Strahlendetektor (2, 20) nach einem der Ansprüche 3 bis 11, wobei das Substrat (5) ein Siliziumsubstrat oder ein Verbund ist, in welchem ein Dünnfilm aus Siliziumdioxid zwischen dem Substrat (5) und dem polykristallinen Diamantfilm (4) bereitgestellt ist.

13. Strahlenmonitor (1), aufweisend einen Strahlendetektor (2, 20) zum Detektieren der Position und Intensität von Synchrotronstrahlen (7), umfassend: den Strahlendetektor (2, 20) nach einem der Ansprüche 1 bis 12; und eine Lichtemissionsüberwachungsvorrichtung (3, 3a) zum Überwachen des emittierten Lichts (8, 8a), wobei durch einen Lichtemissionszustand, überwacht durch die Lichtemissionsüberwachungsvorrichtung (3, 3a), die Position und Intensität der Synchrotronstrahlen (7) detektiert werden.

14. Strahlenmonitor (1) nach Anspruch 13, wobei der freistehende Diamantfilm, bestehend aus dem polykristallinen Diamantfilm (4), dafür geeignet ist, Licht (8, 8a) an einem Strahlenpunkt (7a) zu emittieren, wenn er mit den Strahlen (7) mit einer Energie von 5 bis 300 keV bestrahlt wird, und die Lichtemissionsüberwachungsvorrichtung (3, 3a) eine Kamera einschließt.

## Revendications

1. Détecteur de faisceau (2, 20) pour détecter la position et l'intensité de faisceaux de rayonnement de synchrotron (7), comprenant : au moins un film de diamant autoportant, qui doit être irradié par les faisceaux de rayonnement du synchrotron (7), consistant en un film de diamant (C) polycristallin (4) contenant au moins un élément (X) choisi parmi le groupe consistant en le silicium (Si), l'azote (N), le lithium (Li), le béryllium (Be), le bore (B), le phosphore (P), le soufre (S), le nickel (Ni) et le vanadium (V) à un X/C allant de 0,1 à 1000 ppm, où le film de diamant polycristallin (4) a une fonction d'émission de lumière, qui émet de la lumière (8, 8a) lorsqu'il est irradié par le faisceaux de rayonnement (7).

2. Détecteur de faisceau (2, 20) selon la revendication 1, où le film de diamant autoportant consistant en le film de diamant polycristallin (4) est adapté pour émettre de la lumière en un point de faisceau (7a) lorsqu'il est irradié par les faisceaux de rayonnement du synchrotron (7) à une énergie de 5 à 300 keV.

3. Détecteur de faisceau (2, 20) selon la revendication 1 ou 2, où une partie du film de diamant autoportant est maintenue par un substrat (5) et le film de diamant polycristallin (4) présente une épaisseur allant de 0,1 µm à 3 mm.

4. Détecteur de faisceau (2, 20) selon l'une quelconque des revendications 1 à 3, où le film de diamant polycristallin (4) comprend des grains de diamant ayant un diamètre moyen des grains allant de 0,1 µm à 1 mm.

5. Détecteur de faisceau (2, 20) selon l'une quelconque des revendications 1 à 4, où la longueur d'onde de la lumière émise (8, 8a) se situe dans l'intervalle allant de 150 à 800 nm.

6. Détecteur de faisceau (2, 20) selon l'une quelconque des revendications 1 à 4, où l'émission de lumière (8, 8a) a une intensité maximale dans une région de longueur d'onde allant de 730 à 760 nm.

7. Détecteur de faisceau (2, 20) selon l'une quelconque des revendications 1 à 4, où l'émission de lumière (8, 8a) a une intensité maximale dans une région de longueur d'onde allant de 500 à 600 nm.

8. Détecteur de faisceau (2, 20) selon l'une quelconque des revendications 1 à 7, où le film de diamant polycristallin (4) a une planéité allant de 30 à 100 nm.

9. Détecteur de faisceau (2, 20) selon l'une quelconque des revendications 1 à 8, où une série de films de diamant autoportants est assemblée pour former une structure de module.

10. Détecteur de faisceau (2, 20) selon l'une quelconque des revendications 1 à 9, où le film de diamant polycristallin (4) contient la structure de film autoportant (6) et cette partie de film autoportant (6) est la partie à irradier avec les faisceaux (7).

11. Détecteur de faisceau (2, 20) selon l'une quelconque des revendications 1 à 10, où le film de diamant polycristallin (4) comprend le film de diamant autoportant et une partie de film épais ayant une épaisseur supérieure à celle du film de diamant autoportant.

12. Détecteur de faisceau (2, 20) selon l'une quelconque des revendications 3 à 11, où le substrat (5) est un substrat en silicium ou un composite dans lequel un film fin de dioxyde de silicium est prévu entre le substrat (5) et le film de diamant polycristallin (4).

13. Appareil de surveillance de faisceau (1) ayant un détecteur de faisceau (2, 20) pour détecter la position et l'intensité de faisceaux de synchrotron (7), comprenant : le détecteur de faisceau (2, 20) selon l'une quelconque des revendications 1 à 12, et un moyen d'observation de l'émission de lumière (3, 3a) pour observer la lumière émise (8, 8a), où par un état d'émission de lumière observé par le moyen d'observation de l'émission de lumière (3, 3a), la position et l'intensité des faisceaux de synchrotron (7) sont détectées.

14. Appareil de surveillance de faisceau (1) selon la revendication 13, où le film de diamant autoportant consistant en le film de diamant polycristallin (4) est adapté pour émettre de la lumière (8, 8a) en un point de faisceau (7a) lorsqu'il est irradié par les faisceaux de rayonnement (7) à une énergie de 5 à 300 keV, et le moyen d'observation d'émission de lumière (3, 3a) comprend une caméra.
